# FASCICULE DE BREVET EUROPEEN

(11) **EP 0 827 621 B1**
(45) Date de publication et mention de la délivrance du brevet: **26.01.2000**
(21) Numéro de dépôt: 96917541.3
(22) Date de dépôt: 23.05.1996
(51) Int. Cl.: G11B 7/00, G11B 7/24, G11C 13/04, G02B 6/00

(54) **MEMOIRE DE MASSE OPTIQUE, AINSI QUE PROCEDES DE FABRICATION D'UNE TELLE MEMOIRE ET PROCEDE D'ENREGISTREMENT ET/OU DE LECTURE DE DONNEES DANS UNE TELLE MEMOIRE**
OPTISCHER MASSENSPEICHER SOWIE VERFAHREN ZUR HERSTELLUNG EINES SOLCHEN SPEICHERS UND VERFAHREN ZUM AUFZEICHNEN UND/ODER LESEN VON DATEN IN EINEM SOLCHEN SPEICHER
OPTICAL MASS STORAGE DEVICE, AS WELL AS METHODS OF MANUFACTURING SUCH STORAGE DEVICE AND METHOD OF RECORDING AND/OR READING DATA IN SUCH A DEVICE

(30) Priorité: 23.05.1995 FR 9506554
(43) Date de publication de la demande: 11.03.1998
(73) Titulaire: Labeyrie, Antoine, 04870 Saint-Michel-de-l'Observatoire (FR)
(72) Inventeur: Labeyrie, Antoine, 04870 Saint-Michel-de-l'Observatoire (FR)
(74) Mandataire: Thibon-Littaye, Annick
(86) Numéro de dépôt international: FR9600777
(87) Numéro de publication internationale: WO9637887

(56) Documents cités:
- WO-A-89/06385
- WO-A-95/02880
- US-A- 3 912 391
- US-A- 5 377 176

## Description

La présente invention concerne la conception et la réalisation des mémoires de masse de type optique, telles que les mémoires sur disque optique (ou disque laser), ainsi que l'enregistrement et la lecture de données ou informations stockées en de telles mémoires, au moyen d'un faisceau de lumière laser. Il doit être entendu toutefois que si la conformation en disque aux dimensions standardisées des "disques compacts" répond à des besoins industriels particulièrement importants, elle n'est pas pour autant limitative, des mémoires de masses de mêmes compositions et structures pouvant se présenter sur d'autres formes de supports, par exemple en bandes ou films.

Pour de nombreuses applications, la capacité des mémoires optiques actuelles se révèle très insuffisante. On ne sait y stocker les données qu'en surface d'un revêtement photosensible formé sur une face du disque. Le plus souvent, des micro-cuvettes sur lesquelles le faisceau lumineux est focalisé sont gravées dans une telle couche de revêtement optique, de sorte qu'elles constituent des cellules élémentaires d'enregistrement de données réparties sur la surface sensible. Par la place qu'elles occupent et leur écartement nécessaire, elles sont en densité limitée.

Pour augmenter la capacité mémoire des disques optiques, plusieurs solutions sont actuellement à l'étude. On peut citer : - les disques à double face d'enregistrement, - le fonctionnement en lumière laser de couleur bleue, permettant une légère réduction de taille des cellules élémentaires en accord avec la théorie de la diffraction, - l'empilage de plusieurs couches de revêtement à sensibilité optique, en nombre cependant limité (six par exemple), ce qui en outre impose de défocaliser la lumière à l'entrée de chacune des couches, tant à l'enregistrement qu'à la lecture.

Ces différentes solutions permettent seulement d'augmenter la capacité des disques optiques actuellement commercialisés d'au maximum dix fois, ce qui ne constitue pas un accroissement suffisant pour les besoins de l'industrie.

On peut également envisager d'utiliser des supports comportant plusieurs couches différemment colorées comme dans les pellicules de photographie en couleurs. Mais, en fait, il est difficile d'utiliser plus de quelques couches, du fait des interactions en présence des faisceaux de lumière colorée qui doivent être utilisés pour l'enregistrement et la lecture, si bien que l'accroissement de la capacité mémoire reste limité.

Le problème à la base de la présente invention est donc de fournir une mémoire de masse de type optique présentant une densité de mémoire fortement améliorée par rapport à celle des disques optiques actuels, en permettant avantageusement d'enregistrer des centaines de bits dans l'épaisseur de zones élémentaires de largeur correspondant à la tache d'Airy d'une lentille de microscope, donc de l'ordre du micromètre.

Elle propose pour cela de faire appel à des possibilités d'exploitation holographique en volume d'un matériau photosensible qui ont été explorées par ailleurs, et de combiner ainsi pour le stockage de données, une bonne densité latérale en surface du revêtement optique avec une bonne densité verticale considérée dans son épaisseur.

A cet effet, la présente invention a pour objet une mémoire de masse optique, du type comportant une couche photosensible, formée notamment sur un disque optique, qui comporte des cellules élémentaires réparties sur sa face libre, dont chacune est constituée par un tronçon de guide de lumière, pour l'enregistrement de données lui parvenant dans un faisceau laser auquel elle est exposée, les données ainsi enregistrées pouvant être restituées par lecture au moyen d'un faisceau laser.

La mémoire suivant l'invention est caractérisée en ce que chacun desdits tronçons de guide de lumière de la couche en matière photosensible est formé de façon à être apte à fonctionner en fibre optique monomode orientée à travers ladite couche suivant un axe sensiblement perpendiculaire à la face libre d'enregistrement.

Quand une fibre d'une telle couche est exposée à un faisceau porteur de données, il s'y crée par effet Lippmann des ondes stationnaires de longueurs d'ondes multiples qui, par action sur la matière photosensible, génèrent une structure constituée dans chaque fibre d'une superposition de stratifications périodiques s'empilant sur l'axe dudit tronçon et constituant un interférogramme.

Dans chaque fibre élémentaire d'une couche photo-sensible de mémoire optique suivant l'invention, grâce à sa structure en réseau de fibres monomodes, les données sont ainsi enregistrées sous forme restituable en une stratification des propriétés optiques qui, par cumul des effets périodiques, est globalement apériodique.

Il n'est pas en soi nouveau d'exploiter l'effet Lippmann pour imprimer des couches sensibles. En particulier, le document de brevet américain US-A-3 912 391 rappelle qu'il avait un temps été envisagé d'appliquer les phénomènes à la photographie en couleurs. Il s'agissait alors d'utiliser trois faisceaux lumineux répondant à trois fréquences différentes, chacun en lumière monochromatique cohérente mais anharmoniques entre eux, produisant des ondes stationnaires dont les ventres et noeuds coexistent le long d'un même trajet dans une couche de matériau transparent.

Le même document propose d'enregistrer des données sous forme de stratifications périodiques dans un matériau photosensible dont il fournit un certain nombre d'exemples. Il a aussi l'intérêt de décrire des procédés et dispositifs utilisables lors de l'enregistrement et lors de la lecture. Par contre, chaque exposition d'enregistrement s'effectue en lumière monochromatique, et il est manifeste que l'auteur n'a pas su faire autrement que d'utiliser un masque perforé pour éclairer son matériau lors de l'impression, de manière à séparer les zones d'enregistrement.

Or non seulement un tel masque introduit des perturbations par diffraction avant même l'admission dans le matériau photosensible, mais en outre, rien ne permet d'éviter que les stratifications créées en des zones voisines de ce matériau se contaminent mutuellement par la diffusion d'ondes évanescentes.

Par la création préalable d'un réseau de distribution des propriétés optiques fournissant l'équivalent de fibres guides d'ondes monomodes au sein du matériau, la présente invention permet de s'affranchir des inconvénients qui en résultent, et pour le stockage d'informations reçues en forme optique, elle autorise en combinaison à la fois une forte densité en profondeur de la couche photosensible et une grande densité de répartition en surface.

Le document WO-A-89/06385 décrit un art antérieur plus proche de la présente invention que le précédent, par le fait qu'il prévoit une couche de mémoire photosensible constituée par une multitude de guides de lumière en réseau. En procédant sous une série d'inclinaisons différentes, il y cumule des images optiques sous forme d'hologrammes grâce aux réflexions multiples de la lumière produites en régime de propagation multimode. Il est précisé que les cristaux ou fibres optiques doivent être de section suffisamment importante pour permettre une multiplicité de modes de propagation suivant l'angle sous lequel la lumière pénètre dans la fibre. L'enregistrement de données sous forme d'une pluralité d'hologrammes résulte donc d'un multiplexage angulaire, à la différence de la présente invention qui procède en régime de propagation monomode et par injection axiale de lumière polychromatique.

La couche photosensible de la mémoire optique suivant l'invention est avantageusement disposée sur un substrat transparent la supportant, lequel est notamment en forme de disque, en conformité avec des normes courantes pour les mémoires optiques antérieurement connues.

L'utilisation de l'effet Lippmann permet d'enregistrer une à plusieurs centaines de bits de données à travers l'épaisseur de la couche photosensible dans chaque tronçon de fibre monomode, donc pour chaque zone d'enregistrement, là où, dans la réalité pratique des mémoires de masses disponibles dans le commerce, la capacité de stockage ne savait guère dépasser 1 bit par micromètre carré précédemment, pour des faisceaux laser dont la longueur d'onde se situe dans le domaine visible. On obtient alors un accroissement correspondant de la capacité de la mémoire par rapport aux systèmes antérieurs exploités industriellement.

De plus, le confinement de tout spot d'éclairage, assuré de par la structure fibrée transversalement à la surface accessible de la couche photo-sensible, autorise une densité plus serrée des cellules ou zones élémentaires dans leur répartition sur la surface de la couche d'enregistrement. Ce confinement évite la divergence du faisceau ; il maintient donc sa focalisation, et ce sans difficulté sur toute la longueur des fibres monomodes constituées. Cette longueur est celle de l'épaisseur de couche sensible, avantageusement de quelques dizaines ou centaines de micromètres, ou plus précisément comprise entre 50 et 1000 micromètres.

La matière photosensible utilisée pour constituer chacun des tronçons formant fibre optique, peut être de toute nature en soi connue. Suivant un premier mode de réalisation de l'invention, il s'agit d'une matière photo-réfringente (ou photo-réfractive) dont l'indice de réfraction est modifié par une exposition à la lumière. De tels matériaux photo-réfringents sont soit de nature minérale, comme le niobate de lithium ou du titanate de baryum, soit de nature organique, à base de polymères.

Dans d'autres situations, on préférera utiliser des matériaux dont la photo-sensibilité est plutôt liée à des phénomènes d'aimantation et désaimantation de particules qu'ils comportent, comme c'est le cas des matériaux magnéto-optiques dont l'emploi est récemment apparu pour constituer des mémoires réinscriptibles. Un article publié dans le numéro d'avril 1995 de "PHYSICS TODAY", sous la signature de Awschalom D.D. et Divicenzo D.P., préconise à cette fin une matière faite de molécules organiques incorporant des atomes de fer apportant la susceptibilité à l'aimantation.

Dans d'autres situations encore, une sensibilité équivalente à la lumière laser peut être obtenue grâce à un effet thermique provoquant en quelque sorte un brûlage local de la couche photo-sensible. Dans tous les cas, le phénomène est réversible entre l'enregistrement et la lecture, ou du moins pratiquement réversible moyennant des adaptations appropriées.

Dans le cadre de l'utilisation de matières fondamentalement photo-réfringentes pour la mise en oeuvre de l'invention, on sera en pratique conduit à préférer le plus souvent les matériaux organiques aux semi-conducteurs minéraux plus classiques. En effet, à la suite de recherches relativement récentes dans le domaine de la chimie des macromolécules, l'industrie des polymères sait maintenant fabriquer des matériaux transparents dont on peut régler l'indice de réfraction de manière permanente sous l'effet de la lumière. On pensera notamment à ceux qui sont à base de polymères et copolymères de polyméthacrylates d'alkyle, et plus particulièrement de polyméthylméthacrylate.

Il existe en particulier de tels matériaux qui sont à base de chaînes de polyméthacrylates copolymérisées avec des réticulants du type polyvinyl-pyrrolidone ou polyvinyl-carbazole, en présence d'un initiateur de photo-polymérisation. Le durcissement par réticulation de la composition polymérique correspondante est alors assuré sélectivement dans les régions où cette composition est exposée à un rayonnement lumineux d'intensité appropriée.

La nature des motifs de chaque constituant d'une telle composition, les proportions relatives de ses constituants et celles de substituants complémentaires convenablement choisis, permettent de régler les propriétés optiques, de manière localisée, avec une précision et une sécurité souvent supérieure aux propriétés que présentent les semi-conducteurs cristallins. En particulier, les connaissances acquises en physico-chimie des macromolécules facilitent un réglage différencié, d'une part pour la sensibilité de la composition à une irradiation provoquant une réticulation définitive ponctuelle, et d'autre part pour une photoconductivité également localisée qui dépend de sites actifs, créés par greffage sur les macromolécules qui jouent le rôle de porteurs de charges.

A titre d'exemple, un article publié dans le numéro de janvier 1995 de "PHYSICS TODAY", en pages 17 à 19, indique la composition d'un tel polymère dans lequel l'addition d'un accepteur d'électrons augmente la photosensibilité et celle d'un absorbeur électro-optique apporte l'effet de non-linéarité nécessaire à l'activité photoréfractive. En plus, la présence d'un plastifiant favorise l'alignement des dipôles présents au sein des motifs chromophores électro-actifs avec la direction d'un champ électrique. Avec des compositions de ce genre, on peut obtenir des matériaux transparents de structure extrêmement fine dans lesquels la répartition des sites à moment électrique se situe à l'échelle du nanomètre.

D'autres caractéristiques de l'invention concernent la réalisation de la constitution physique de la couche photo-sensible en structure fibrée faite de fibres optiques monomodes.

Conformément à l'un des modes de réalisation de l'invention de ce point de vue, les tronçons de guide optique peuvent être obtenus à partir de puits creusés dans la surface d'un substrat, en remplissant ces puits avec une résine de polymère photo-réfringent sous forme liquide qui est ensuite durcie sous forme solide.

Toutefois, suivant l'invention, on préfère réaliser les tronçons de fibre optique par un procédé holographique, qui consiste à soumettre une couche de matière photo-réfringente, préalablement à toute opération d'inscription de données, au rayonnement simultané de plusieurs faisceaux laser collimatés, de manière à générer par leurs interférences une configuration de réseau qui pénètre et s'incruste en épaisseur, dans la mesure où il n'intervient pas d'effet de focalisation.

D'une manière générale, il est approprié pour cela d'utiliser un minimum de trois faisceaux de lumière cohérente orientés vers la couche de matériau photo-réfringent dans des directions respectives à 120 degrés l'une de l'autre. On obtient alors un réseau de fibres monomodes en nid d'abeilles, où pour trois faisceaux, le réseau est en répartition hexagonale.

Toutefois, on a pu observer qu'il est plus avantageux d'utiliser dans la même opération un plus grand nombre de faisceaux, en pratique préférentiellement quatre, auquel cas la répartition en nid d'abeilles obtenue est plus précisément celle d'un quadrillage, notamment à mailles carrées.

L'invention porte également sur les moyens à utiliser préférentiellement pour effectuer l'enregistrement et la lecture de données dans une mémoire de masse telle que définie ci-dessus.

Ces moyens sont pour partie classiques, en ce qui concerne notamment les matériels de focalisation des faisceaux laser sur l'entrée d'une cellule ou zone élémentaire d'enregistrement et de déplacement pour parcourir de telles cellules successivement par un même faisceau.

Par contre, on a tout intérêt à utiliser des dispositifs d'émission ou réception laser dont le fonctionnement a lui aussi recours à l'effet Lippmann. On se reportera ici avec profit à la description qui en figure dans une autre demande de brevet déposée le même jour par le même demandeur, sous le titre "Procédé et dispositifs d'émission ou réception laser pour la transmission d'informations par voie optique" (brevet France 9506104 déposé le 23 mai 1995).

Les caractéristiques et avantages de l'invention ressortiront mieux de la description qui suit d'exemples de réalisation particuliers, faite en se référant aux dessins ci-annexés sur lesquels:
- la figure 1 représente de manière schématique, pour une partie seulement de la surface d'enregistrement, la structure essentielle d'une mémoire de masse optique conforme à la présente invention ;
- la figure 2 illustre schématiquement la formation des stratifications de Lippmann dans les fibres optiques monomodes constituant une telle couche de mémoire optique ;
- la figure 3 représente schématiquement un premier mode d'enregistrement et de lecture des informations ;
- et la figure 4 illustre un deuxième mode d'enregistrement et de lecture.

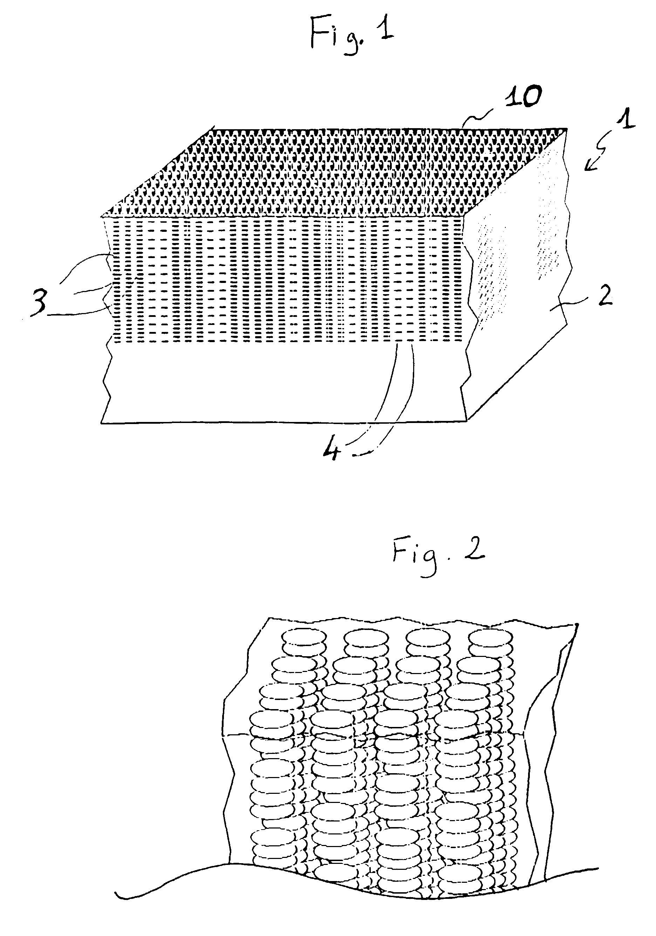

La coupe partielle de la figure 1 montre comment se présente, en sa structure interne, la face d'enregistrement de données sur un disque laser à mémoire optique réalisé suivant l'invention, en admettant que des informations ou données y ont déjà été enregistrées. Cette structure peut être qualifiée de structure de Lippmann, dans la mesure où elle présente la trace inscrite d'interférogrammes générés par effet Lippmann.

On sait que l'on entend par là une structure produite dans une couche photosensible en noir et blanc dans laquelle on a formé des ondes lumineuses stationnaires qui ont donné lieu à de fines stratifications dans l'épaisseur de la couche. Après une opération de développement appropriée, on observe une superposition de stratifications périodiques dont chacune provient d'une des longueurs d'onde présentes dans un faisceau lumineux auquel la couche a été exposée et possède une période égale à la moitié de cette longueur d'onde. On a pu réaliser ainsi une photographie en couleurs que l'on restitue par réflexion d'un faisceau de lumière blanche. Cette technique a aussi été utilisée pour réaliser des hologrammes.

La présente invention implique une structure de ce type dans une couche de matière photosensible 1 déposée sur un substrat 2. Cette couche 1 comporte, sur la face libre d'enregistrement 10, pour chaque zone élémentaire correspondant à la tache d'Airy d'une lentille de microscope utilisée pour la lecture, un tronçon de guide de lumière, assimilable à un tronçon de fibre optique monomode, présentant une structure optique quasi-transparente.

Chacun de ces tronçons agit comme un guide de lumière monomode séparé, apte à recevoir une structure de Lippmann. Le profil des stratifications périodiques qui y sont créées lors de l'enregistrement de données est un interférogramme qui est la transformée de Fourier du spectre du faisceau lumineux d'enregistrement.

A la lecture, la structure enregistrée a pour effet de réfléchir sélectivement une série de différentes longueurs d'ondes de lumière. Si l'on peut admettre que l'interaction avec la lumière est linéaire, la dépendance spectrale du coefficient de réflexion de la structure est La transformée de Fourier du profil décrivant l'indice de réfraction, réel ou complexe, de la stratification. Le spectre de la lumière utilisée pour l'enregistrement est ainsi fidèlement restitué dans la lumière réfléchie lors de la lecture.

Sur la figure 1, on a représenté schématiquement de tels tronçons de fibre optique monomode 3 et 4, avec leurs stratifications. Certains tronçons 4 présentent des stratifications plus larges, qui correspondraient par exemple à la réflexion de lumière rouge ; d'autres tronçons 3 montrent une stratification à périodicité moins large, qui correspondrait par exemple à la réflexion de lumière bleue. Toutefois, dans chacun de ces tronçons, la stratification est apériodique dans la réalité de la mise en oeuvre de l'invention, du fait qu'elle correspond à un cumul de différentes longueurs d'ondes en un spectre intégrant les informations d'une série de données.

La stratification d'une fibre implique une modulation de son indice de réfraction le long de son axe. Le profil des indices est la transformée de Fourier du spectre du faisceau de lumière utilisé pour l'enregistrement. Selon la loi de Bragg, chaque composante sinusoïdale de la stratification réfléchit une lumière caractérisée par une longueur d'onde lumineuse distincte qui lui est propre, en correspondance avec une valeur de longueur d'onde qui, dans le milieu transparent, est égale à deux fois la période de la composante sinusoïdale.

L'information enregistrée dans une fibre est lue en envoyant un faisceau laser à large bande dans la fibre et en effectuant une analyse spectrale de la lumière réfléchie. Ceci peut être réalisé en utilisant une lentille de microscope pour projeter un point (ou spot) de lumière laser à l'entrée de la fibre et en récupérant la lumière réfléchie pour analyse.

Dans un mode de réalisation particulier, l'espace séparant deux tronçons verticaux de fibre optique est de l'ordre de 0,5 à 2 micromètres, et la longueur de chacun s'étend sur une épaisseur de couche comprise entre 20 et 200 micromètres. En pratique, pour une meilleure fidélité, on préférera augmenter l'épaisseur de la couche sensible à des valeurs de 100 à 500 micromètres. La largeur des fibres en tranche transversale reste toujours proche des longueurs d'ondes lumineuses. Il s'agit en particulier de largeurs de 0,5 micromètres réparties suivant un réseau au pas de 1,4 micromètres, comme on a su les obtenir par une technique décrite plus loin.

La répartition des fibres sur la surface d'enregistrement correspond à celle d'un réseau en nid d'abeilles illustré en 10 sur la figure 1. Il s'agit préférentiellement d'un réseau de type quadrillage, à mailles carrées comme illustré par la figure 2, plutôt que d'un réseau à mailles hexagonales, chaque configuration étant liée au procédé choisi pour créer le réseau en faisceau de fibres monomodes préalablement à tout enregistrement de données. Dans tous les cas, le pas du réseau est suffisamment faible pour que chaque tronçon du réseau soit apte à fonctionner comme une fibre optique monomode, tant à l'enregistrement qu'à la lecture.

Les tronçons de fibre optique, ou plus généralement l'ensemble de la couche photosensible, avec les fibres qui la composent, sont réalisés en une matière photo-réfringente, c'est-à-dire une matière dont l'indice de réfraction, modifié par exposition à la lumière, dépend de l'éclairage reçu localement. Cette propriété permet d'imprimer un réseau d'interférences au sein de la matière.

Suivant la nature du matériau choisi, elle peut impliquer le fait que, dans les régions à forte intensité lumineuse, l'absorption soit capable de créer à la fois des charges positives et négatives qui se séparent et se redistribuent, en donnant naissance à un champ électrique qui, à son tour, entraîne une variation de l'indice de réfraction.

Pour constituer la matière photo-réfringente, on peut par exemple utiliser du niobate de lithium ou du titanate de baryum. Préférentiellement, on utilisera des matériaux organiques tels que les polymères photo-réfringents.

Après que l'enregistrement des données ait été réalisé, la modulation axiale de l'indice de réfraction de chaque tronçon de fibre optique est stabilisée par un traitement physique et/ou chimique approprié, que l'on choisira en fonction du matériau photo-réfringent utilisé.

Pour fabriquer des disques optiques selon l'invention, ou des couches analogues constituant mémoire de masse pour l'enregistrement de données, on peut utiliser différents procédés.

On rappellera donc ici qu'il est possible de réaliser, dans la face supérieure d'un substrat, des puits que l'on remplit ensuite avec une résine photo-réfringente sous forme liquide qui est ensuite solidifiée, avant ou après la phase d'enregistrement. Aux largeurs d'ordre de grandeur micronique utiles ici, on peut donc envisager de réaliser de tels puits par moulage, en utilisant une matrice qui crée les puits dans une couche photo-réfringente portée par un substrat appropriée. Cette technique de moulage est comparable à celle utilisée pour produire des copies de réseaux de diffraction et des réseaux de micro-lentilles. La couche photosensible moulée et son substrat constituent alors une couche unique, comme cela est réalisé dans les phases initiales de la fabrication des disques optiques connus.

Toutefois, dans le cadre de la présente invention, il est largement préférable, pour fabriquer la couche 1 en son réseau de tronçons de fibre optique monomodes, d'utiliser une technique de fabrication par voie photochimique, dérivant de celle qui est décrite par A. Labeyrie dans la revue "Electro-Optical Systems Design" de février 1971, pages 32 à 38.

A titre d'exemple illustrant bien la mise en oeuvre de l'invention, on utilise une couche de polymère photo-réfringent de 100 à 300 micromètres d'épaisseur, le matériau étant fait d'une résine commercialisée sous la dénomination Omnidex 600 par la société Du Pont de Nemours.

En pratique, cette société commercialise toute une série de matériaux de ce genre, sous la forme de films protégés provisoirement entre deux feuilles de polyéthylène téréphtalate, ou Mylar. Ces compositions, telles qu'elles sont décrites pour des enregistrements holographiques et des duplications par contact, dans l'article "Hologram recording in Du Pont's new photopolymer materials", publié par Weber et al. dans "Practical Holography", IV, SPIE OE/Lase Conférence Proceedings, 1212-04, Los Angeles, CA, Jan. 14-19, 1990), sont à base d'une composition comprenant un liant polymérique, des monomères polymérisables, un système promoteur de photo-polymérisation, et des agents de photo-sensibilisation actifs sous des longueurs d'ondes déterminées, avec en plus des additifs de type plastifiants et surfactifs qui permettent d'en régler les propriétés physico-chimiques.

Pour la fabrication de la couche mémoire de données suivant l'invention, cette couche de matériau photo-réfringent est fixée sur un substrat en matière synthétique transparente. Elle est alors irradiée sur l'ensemble de sa surface libre par une pluralité de faisceaux laser collimatés, au moins au nombre de trois comme décrit par l'article cité en référence.

Préférentiellement, il s'agit de quatre faisceaux de lumière cohérente, dirigés vers la surface chacun sous un même angle de l'ordre de 20 à 30 degrés, les quatre faisceaux se situant dans des plans d'incidence à 90 degrés l'un de l'autre, comme les arêtes d'un tétraèdre régulier.

Cette exposition crée un réseau d'interférences en forme de nid d'abeilles ou de quadrillage de cellules qui pénètre dans le volume du polymère photo-réfringent, à travers toute l'épaisseur de la couche, du fait que le réseau d'interférences est insensible à la focalisation. Il s'ensuit une modification correspondante des propriétés locales du matériau ainsi irradié. Dans le cas présent, il s'agit d'une modulation de l'indice de réfraction d'origine du matériau, avec formation de l'équivalent de fibres guides d'ondes monomodes, en distribution transversale régulière à travers toute l'épaisseur de la couche utilisée, relativement épaisse.

Bien entendu, une autre exposition est nécessaire pour enregistrer les données dans chaque fibre. C'est ainsi que l'on obtient une structure telle que celle de la figure 2, schématisant un fragment d'enregistrement par effet Lippmann dans un réseau de fibres à mailles carrées tel que préalablement engendré par l'interférence de 4 faisceaux.

L'indice de réfraction de la matière est plus élevé dans les fibres que dans le milieu intercalaire qui les sépare, ce qui assure le guidage de la lumière injectée à l'entrée de chaque fibre lors de l'écriture ou la lecture. Cet indice de réfraction est lui-même modulé dans chaque fibre en strates produites par une stratification de Lippmann polychromatique. Chaque fibre garde ainsi la mémoire d'autant de bits d'information qu'il lui en est parvenu sous forme codée dans, par exemple 100 longueurs d'ondes différentes d'un même faisceau.

Différentes longueurs d'onde des faisceaux laser peuvent être utiles pour réaliser l'exposition globale initiale et les expositions locales d'enregistrement, ainsi que pour des étapes intermédiaires du processus. Par exemple, la formation des tronçons de fibre optique peut être réalisée avec une exposition à un rayonnement violet ou ultraviolet, suivie d'une étape de stabilisation de la structure de tronçons de fibres optiques, puis d'une étape de sensibilisation pour la réponse en lumière visible.

Suivant une variante de l'invention, particulièrement avantageuse pour une concrétisation industrielle, on fera appel à d'autres matériaux particulièrement adaptés pour l'enregistrement et la lecture de données par voie optique, comme il en a été proposé récemment. On se réfère ici en particulier à l'article publié dans le numéro du 3 mai 1996 de la revue Science sous les signatures de Sato et al. Il y est mis en évidence un effet d'aimantation photo-induite pour du cyanure de cobalt-fer intégré dans une molécule organique, avec toutefois comme inconvénient que leur fonctionnement demande une utilisation à basse température.

Ces différents procédés permettent d'obtenir des tronçons de fibre optique dans lesquels on peut enregistrer plusieurs centaines de bits, ce qui permet d'envisager des disques optiques avec une capacité mémoire de cent gigaoctets par décimètre carré.

La lecture des données enregistrées s'effectue pour chaque tronçon de fibre optique en envoyant un faisceau laser focalisé sur le tronçon de manière à introduire une onde guidée dans le tronçon. Si le faisceau laser est à large bande, certaines longueurs d'onde sont réfléchies par la structure stratifiée enregistrée dans le tronçon, selon l'effet Lippmann, et sont renvoyées vers le laser.

Un dispositif de fractionnement des rayons envoie le faisceau en retour sur un détecteur à analyse spectrale. Cette détection peut être réalisée au moyen d'un spectrographe miniature, en utilisant, par exemple, un sélecteur de mode et un réseau linéaire de diodes pour une lecture rapide en parallèle. On peut également utiliser un spectrographe parallèle de Fourier, par exemple sous la forme d'un réseau de diodes stratifié, utilisant encore l'effet Lippmann, qui fait l'objet de la demande de brevet déposée simultanément déjà mentionnée.

Pour accélérer la lecture, en lisant simultanément plusieurs tronçons, le laser unique peut être remplacé par une série de lasers, auquel cas on utilise également une série de détecteurs à analyse spectrale.

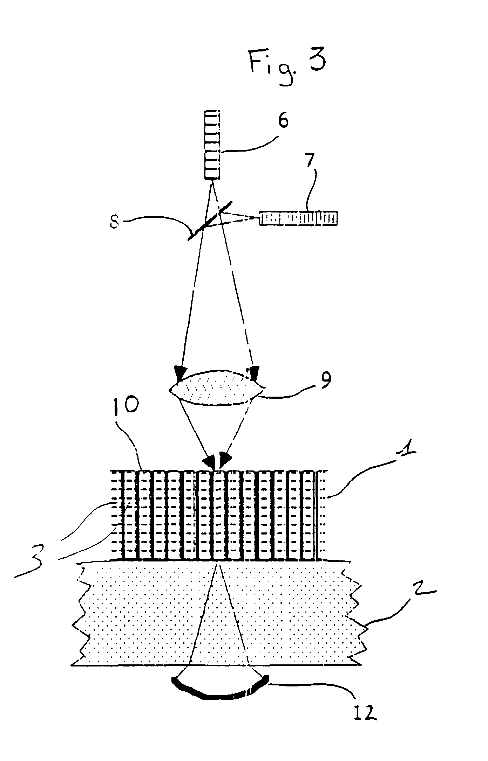

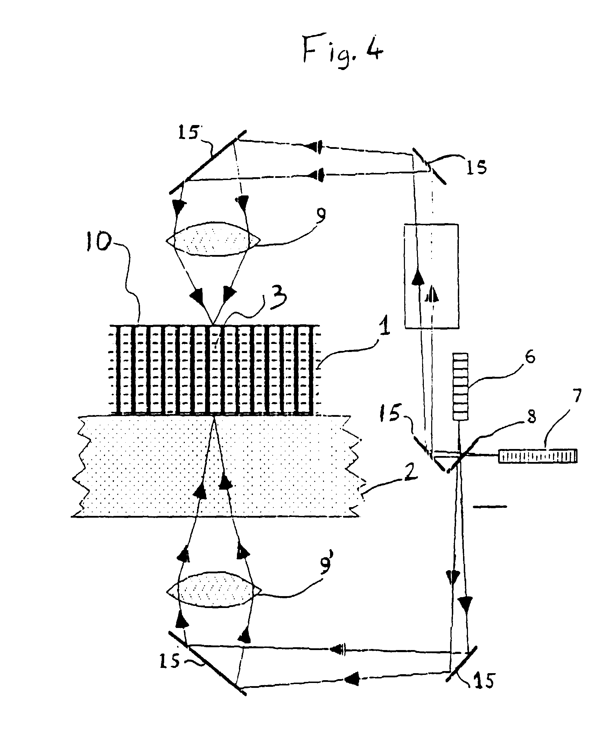

Les figures 3 et 4 représentent chacune un dispositif permettant l'enregistrement et la lecture de données dans une mémoire optique selon l'invention. La couche 1 et le substrat 2 sont représentés partiellement en coupe. Dans les deux cas, pour l'enregistrement, on utilise seulement un émetteur laser 6 dont le spectre lumineux instantané emporte avec lui l'information globale de données multiplexées par modulation simultanée d'une série de courants d'excitation de l'émetteur, comme il est décrit dans la même demande de brevet que ci-dessus. Lors de la lecture, le faisceau issu d'un laser 6 traverse la lame semi-transparente 8, servant à diriger vers le détecteur 7 la lumière que rétro-diffracte le disque.

Une lentille 9 focalise le faisceau à l'entrée d'un tronçon de fibre 3. Lors de l'enregistrement de données, la lumière pénétrant la fibre en ressort à l'autre extrémité, traverse le substrat transparent 2, atteint un miroir sphérique 12 qui renvoie la lumière en la refocalisant sur l'extrémité du tronçon de fibre. Le matériau photo-réfringent de ce tronçon est ainsi exposé à l'action de deux faisceaux se propageant en sens inverse, dont l'interférence engendre des ondes stationnaires. Ces ondes stationnaires inscrivent dans le matériau photosensible de la fibre une superposition de stratifications d'indices de réfraction selon l'effet Lippmann.

Lors de la lecture de données préalablement enregistrées, le laser 6 émet un spectre continu de lumière, et le miroir 12 est masqué. Certaines longueurs d'ondes sont sélectivement réfléchies vers le laser 6 et le détecteur 7 par la structure Lippmann enregistrée. Le détecteur 7, qui est lui-même une version photo-électrique de la plaque Lippmann considérée comme détecteur spectrographique, émet une série de signaux électriques dont la distribution est la transformée de Fourier du spectre réfléchi par la fibre.

Pour accélérer l'enregistrement et la lecture, il est possible d'utiliser plusieurs sources laser en parallèle, disposées de façon que leurs faisceaux focalisés par une seule lentille 9 pénètrent en plusieurs fibres voisines. Il peut aussi être avantageux d'utiliser plusieurs têtes d'enregistrement et de lecture.

La figure 4 représente une variante dans laquelle le miroir 12 est supprimé. Lors de l'enregistrement, le faisceau venant du laser et que réfléchit partiellement la lame semi-transparente 8 est envoyé par l'intermédiaire de miroirs 15 et de lentilles 9 et 9' vers les faces respectives inférieure et supérieure de la fibre, où il est focalisé. Les faisceaux pénétrant une même fibre par l'une et l'autre de ses extrémités engendrent ainsi des ondes stationnaires comme dans le cas précédent. Lors de la lecture, l'un des faisceaux est inutilisé, et la détection du faisceau réfléchi par effet Lippmann est effectuée par le détecteur 7 comme précédemment.

Entre l'enregistrement et la lecture, le disque peut être soumis à un traitement physique ou chimique destiné à développer ou stabiliser l'image latente.

En effectuant une compensation appropriée du chemin optique et de la dispersion, on peut obtenir une frange centrale symétrique dans le tronçon 3. Si on utilise un miroir comme dans le cas de la figure, on peut utiliser des techniques de modulation de fréquence d'impulsion pour optimiser l'interférogramme obtenu en ce qui concerne sa cohérence temporelle et son contraste. Ceci implique le déphasage des composantes de la stratification obtenues pour différentes longueurs d'onde, en utilisant des éléments dispersifs dans un des trajets de l'interféromètre ou des miroirs multi-diélectriques conçus de manière appropriée.

L'enregistrement des différentes longueurs d'onde est simultané si on procède comme décrit ci-dessus, mais il pourrait être séquentiel, dans des variantes de mise en oeuvre de l'invention qui semblent toutefois moins avantageuses.

Pour la lecture, le miroir 12 de la figure 3 est supprimé ou un obturateur 14 mis en place de manière à masquer le faisceau prélevé par la lame semi-transparente 8 ; dans les deux cas, le laser envoie un faisceau à large bande et le réseau de diodes 7 constitue le détecteur à analyse spectrale.

Selon une autre variante non représentée, une couche réfléchissante déposée directement sur l'une ou l'autre des faces de l'ensemble de la couche 1 et du substrat 2 sert à engendrer les ondes stationnaires ; il peut cependant être nécessaire de la retirer ou de la rendre transparente pour la lecture.

La mémoire optique selon l'invention est particulièrement destinée à la fabrication de systèmes enregistreurs et lecteurs pour le stockage à haute densité de données numériques ou analogiques sur des disques ou des plaques. Elle est également destinée à la fabrication de disques fixes ou amovibles ou de bandes ou films portant des données.

Il semble présentement que l'invention trouvera sa meilleure voie sous la forme d'une mémoire d'enregistrement de données en couche sur un disque support monté rotatif dans un lecteur de disque optique type compact ou CD-ROM, mais un système à tête laser tournante et disque fixe pourrait également convenir. Par ailleurs, les enregistrements pourront faire l'objet de duplications par transfert optique de disque à disque.

Il est intéressant de remarquer que quand l'invention permet de multiplier la capacité de stockage par un ou deux ordres de grandeur (par exemple 50 à 200), ce résultat n'est pas tributaire de la longueur d'onde de la lumière d'enregistrement et/ou de lecture, ni de la vitesse de rotation d'un disque muni de la couche photosensible d'enregistrement de données. En conséquence, un lecteur des données, ou un lecteur/enregistreur des données dans une couche mémoire réinscriptible, pourront être réalisés sous une forme permettant leur compatibilité avec les systèmes actuels et l'utilisation des disques optiques existants.

## Revendications

1. Mémoire de masse optique, telle qu'un disque optique, comportant une couche photosensible (1) à cellules élémentaires d'enregistrement de données réparties sur sa face libre d'enregistrement (10) et chacune constituée par un tronçon (3) de guide de lumière, caractérisée en ce que chacun desdits tronçons (3) de guide de lumière est formé de façon à être apte à fonctionner en fibre optique monomode orientée à travers ladite couche suivant un axe sensiblement perpendiculaire à la face libre d'enregistrement (10).

2. Mémoire suivant la revendication 1, caractérisée en ce que les tronçons fonctionnant comme des fibres optiques monomodes présentent une largeur de l'ordre du micromètre et en ce qu'ils sont répartis transversalement suivant un pas régulier dans l'épaisseur de ladite couche, et en ce que chacun de ces tronçons est apte à stocker une structure de Lippmann formée d'une superposition de stratifications périodiques disposées selon l'axe du tronçon (3) et constituant un interférogramme de données codées dans les longueurs d'ondes d'un faisceau lumineux.

3. Mémoire suivant la revendication 1 ou 2, caractérisée en ce que les tronçons (3) de guide optique monomode sont en matière photo-réfringente.

4. Mémoire selon l'une quelconque des revendications 1 à 3, caractérisée en ce que la couche photosensible (1) est disposée sur un substrat transparent (2).

5. Mémoire selon l'une quelconque des revendications 1 à 4, caractérisée en ce que la matière de ladite couche renferme un composé à aimantation photo-induite.

6. Mémoire selon l'une quelconque des revendications 1 à 5, caractérisée en ce que la matière de ladite couche est photo-réfringente et réalisée en un polymère photo-polymérisable contenant un agent de photo-sensibilisation.

7. Mémoire selon l'une quelconque des revendications 1 à 6, caractérisée en ce que l'épaisseur de ladite couche photo-sensible est comprise entre 50 et 1000 micromètres.

8. Procédé de fabrication d'une mémoire de masse de type optique, se présentant sous la forme d'une couche photo-sensible supportée par un substrat transparent conformément à l'une quelconque des revendications 1 à 7, caractérisé en ce que l'on soumet ladite couche aux rayonnements de faisceaux de lumière cohérente lui parvenant simultanément, de sorte que leurs interférences entraînent holographiquement la formation d'un réseau de tronçons guides d'ondes en régime monomode à travers l'épaisseur de ladite couche.

9. Procédé de fabrication d'une mémoire de masse de type optique, se présentant sous la forme d'une couche photo-sensible supportée par un substrat transparent conformément à l'une quelconque des revendications 1 à 7, caractérisée en ce que les tronçons (3) de guide optique aptes à fonctionner en régime monomode sont obtenus en creusant des puits dans la surface d'un substrat ou en les ménageant par moulage au moyen d'une matrice, et en remplissant ces puits avec une résine photo-réfringente sous forme liquide qui est ensuite solidifiée.

10. Procédé d'enregistrement et/ou de lecture de données caractérisé en ce qu'il fait application d'une mémoire selon l'une quelconque des revendications 1 à 7, notamment telle qu'obtenue par le procédé de fabrication de la revendication 8 ou 9, par enregistrement desdites données sous forme de structures de Lippmann au sein des tronçons guides de lumière fonctionnant en fibres optiques monomodes à travers la couche de matière photosensible, l'enregistrement et la lecture s'effectuant au moyen d'un faisceau de lumière polychromatique introduite séparément dans chacun desdits tronçons.

## Patentansprüche

1. Optischer Massenspeicher in der Art einer optischen Scheibe, enthaltend eine photosensible Schicht (1), bestehend aus elementaren Zellen zur Speicherung von Daten, welche auf ihrer freien Aufzeichnungs-Oberfläche (10), verteilt sind, wobei jede der elementaren Zellen von einem Teilstück (3) eines Lichtleiters gebildet wird, **dadurch gekennzeichnet, daß** jedes der genannten Teilstücke (3) der Lichtleiter derart gebaut ist, daß es dazu geeignet ist, als optische Monomode-Faser zu funktionieren, welche quer durch die genannte Schicht einer im wesentlichen zur freien Aufzeichnungs-Oberfläche (10) senkrecht stehenden Achse folgt.

2. Speicher nach Anspruch 1, dadurch gekennzeichnet, daß die wie optische Monomode-Fasern funktionierenden Teilstücke eine Breite von der Größenordnung Mikrometer aufweisen, und dadurch gekennzeichnet, daß sie transversal entsprechend einem gleichmäßigen Abstand in der Dicke der genannten Schicht verteilt sind, und dadurch, daß jedes dieser Teilstücke in der Lage ist, eine Lippmannsche Struktur zu speichern, welche von einer Überlagerung von periodischen Schichtungen gebildet wird, die entlang der Achse des Teilstückes (3) angeordnet sind, und ein Interferogramm von Daten, welche in den Wellenlängen eines Lichtbündels codiert enthalten sind, darstellen.

3. Speicher nach Anspruch 1 oder 2 dadurch gekennzeichnet, daß die Teilstücke (3) des optischen Monomode Leiters aus lichtabhängig brechungsaktivem Material bestehen.

4. Speicher nach einem der Ansprüche 1 bis 3, dadurch gekennzeichnet, daß die photosensible Schicht (1) auf einem transparenten Substrat (2) angeordnet ist.

5. Speicher nach einem der Ansprüche 1 bis 4 dadurch gekennzeichnet, daß das Material der genannten Schicht eine licht-induziert magnetisierbare Verbindung einschließt.

6. Speicher nach einem der Ansprüche 1 bis 5, dadurch gekennzeichnet, daß das Material der genannten Schicht lichtabhängig brechungsaktiv ist und als ein photopolymerisierbares Polymermaterial, das einen Wirkstoff zur Photosensibilisierung enthält, realisiert ist.

7. Speicher nach einem der Ansprüche 1 bis 6, dadurch gekennzeichnet, daß die Dicke der genannten photosensiblen Schicht zwischen 50 und 1000 Mikrometern liegt.

8. Verfahren zur Fertigung eines Massenspeichers optischen Typs, in der Form einer photosensiblen Schicht, getragen von einem transparentem Substrat, gemäß einem der Ansprüche 1 bis 7, dadurch gekennzeichnet, daß man die genannte Schicht der Strahlung von kohärenten Lichtbündeln aussetzt, die gleichzeitig derart auf sie auftreffen, daß ihre Interferenzen auf holographische Weise die Bildung eines Gitters von Teilstücken von Wellenleitern im Monomoden-Regime, quer durch die Dicke der genannten Schicht, mit sich bringen.

9. Verfahren zur Fertigung eines Massenspeichers optischen Typs, in der Form einer photosensiblen Schicht, getragen von einem transparentem Substrat, gemäß einem der Ansprüche 1 bis 7, dadurch gekennzeichnet, daß die Teilstücke (3) des optischen Leiters, die dazu geeignet sind, im Monomoden-Regime zu funktionieren, dadurch gebildet werden, daß Vertiefungen in der Oberfläche eines Substrates eingelassen werden oder daß die Vertiefungen durch Gießtechnik vermittels einer Gießform herbeigeführt werden und diese Vertiefungen mit einem lichtabhängig brechungsaktiven Harz in flüssiger Form, das sodann aushärtet, gefüllt werden.

10. Verfahren zum Aufzeichnen und/oder Lesen von Daten, dadurch gekennzeichnet, daß es einen Speicher gemäß der Ansprüche 1 bis 7 anwendet, insbesondere der Art, wie durch das in Ansprüchen 8 oder 9 beschriebene Verfahren erhalten, durch Aufzeichnen der genannten Daten in der Form von Lippmannschen Strukturen mitten in den Teilstücken der Lichtleiter, welche als optische Monomoden-Fasern, quer durch die Schicht aus photosensiblem Material, funktionieren, wobei das Aufzeichnen und das Lesen vermittels eines polychromatischen Lichtbündels geschieht, welches separiert in jedes der genannten Teilstücke eingestrahlt wird.

## Claims

1. An optical mass memory, such as an optical disc, comprising a light-sensitive layer (1) having elementary cells distributed across a free recording face (10) thereof for recording information data, each said elementary cell consisting of a light guiding rod (3), characterized in that each of said light guiding rods (3) is constructed to be operative as a monomode optical fibre directed across said layer with its axis substantially orthogonal to the free recording face (10).

2. A memory according to claim 1, characterized in that said rods operative as monomode optical fibres are of one micrometre range width and are transversally distributed along with a regular pitch across the layer depth, and in that each of said rods is capable of storing a Lippmann's structure formed by a stack of superposed periodic stratifications arranged along the axis of said rod (3) which constitutes an interferogram of information data coded in the wavelengths of a light beam.

3. A memory according to claim 1 or 2, characterized in that said single-mode optical guide rods (3) are made of a photo-refractive material.

4. A memory according to any of claims 1 to 3, characterized in that said light-sensitive layer (1) is supported on a transparent substrate (2).

5. A memory according to any of claims 1 to 4, characterized in that the material for said layer comprises a compound showing photo-induced magnetization.

6. A memory according to any of claims 1 to 5, characterized in that the material for said layer is a light-refractive material made of a photo-polymerizing polymer comprising a photo-sensitizing agent.

7. A memory according to any of claims 1 to 6, characterized in that the thickness of said photo-sensitive layer ranges from 50 to 1000 micrometres.

8. A process for manufacturing an optical-type mass memory comprised of a light-sensitive layer supported by a transparent substrate according to any of claims 1 to 7, characterized in that said layer is exposed to illumination by coherent light beams simultaneously directed to it, whereby their interferences result holographically in creating a pattern of monomode-operative light guiding rods accross the depth of said layer.

9. A process for manufacturing an optical-type mass memory comprised of a light-sensitive layer supported by a transparent substrate according to any of claims 1 to 7, characterized in that said monomode operative optical guide rods (3) are obtained by digging pits in the surface of a substrate or by moulding them from a master, and by filling these pits with a photo-refractive resin in liquid form and subsequently solidifying said resin.

10. A process for recording and/or reading data using a memory according to any of claims 1 to 7, particularly such as obtained through the manufacturing process of claim 8 or 9, through recording said data in the form of Lippmann's structures within said light guiding rods operating as single-mode optical fibres across the layer of photo-sensitive material, recording and reading being achieved using a polychromatic light beam directed separately into each of said rods.
